# EUROPEAN PATENT APPLICATION

(11) **EP 0 568 132 A2**
(43) Date of publication of application: **03.11.1993**
(21) Application number: 93201025.9
(22) Date of filing: 07.04.1993
(51) Int. Cl.: G06F 11/26

(54) **Test generation by environment emulation**

(30) Priority: 30.04.1992 US 876566
(71) Applicant: SCHLUMBERGER TECHNOLOGIES, INC., San Jose, California 95110-1397 (US)
(72) Inventor: West, Burnell G., Fremont, California 94539 (US)
(74) Representative: Smith, Keith

(57) **Abstract**

Generation, validation and fault-grading of test patterns, and test and debug of logic circuits, are enhanced by emulation of the circuits. Two emulations of the circuit are created, a "good" model containing no faults and a "faultable" model into which faults may be selectively introduced. A fault is introduced, and the two models are exercised using the same pattern of test vectors. The pattern may be generated by a emulation of the intended operating environment of the circuit. Differences in output signals of the two models indicate fault detection. The test pattern is repeated for each of a sequence of faults to determine the extent to which the test pattern enables detection of faults. A fault dictionary is produced which indicates the vector at which each fault is detected, the output signal differences indicative of fault detection, and a log of the faults detected. The faultable emulation is used for device testing by comparing its outputs to those of a logic circuit, and for device debug.

## Description

### BACKGROUND OF THE INVENTION

### 1. Field of the Invention

This invention relates to test pattern generation and execution by environment emulation. In particular, the invention relates to emulation of an integrated circuit device ad its intended operating environment to facilitate generation of test patterns having improved fault-detection coverage.

### 2. The Prior Art

Fabrication of integrated circuit (IC) devices before design verification is unacceptable due to the cost of first-article fabrication. Past attempts to solve this problem used circuit-level simulators, switch-level simulators, gate-level simulators, then register-transfer-level and behavioral simulators, ad finally mixed-mode simulators combining features of all. Still, creating and exploring a complex design remains the biggest development cost.

Simulations can run hours or days, but only exercise complex devices in a rudimentary way. Many devices have performance flaws not detected by simulation, because the simulation did not contain the conditions required to exhibit the flaws. Whether the device will do what it should is not known until the device is built and checked, in the system. The cost of system prototype assembly is risked on unproven designs.

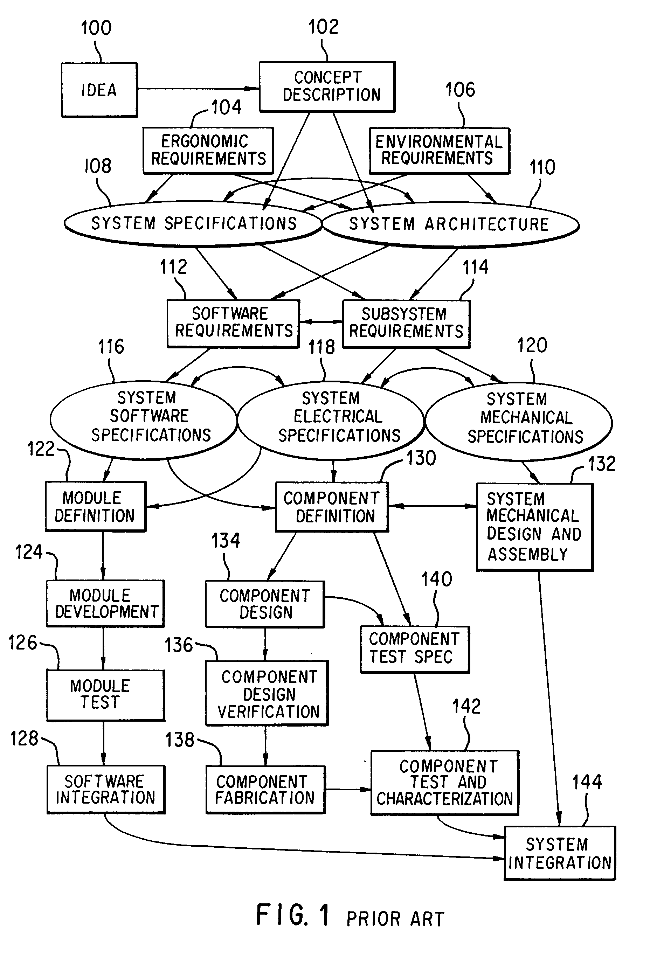

Figure 1 illustrates a methodology traditionally employed in design of IC-based systems. Beginning with an initial idea 100, a concept description 102 is prepared, ergonomic and environmental requirements 104, 106 are established, and system specifications and architecture 108, 110 are defined. Software and subsystem requirements 112, 114 are defined, from which the system software, electrical and mechanical specifications 116, 118, 120 are developed. Software module definition, development, testing and integration 122, 124, 126, 128 are performed.

Component definition 130 follows from system specifications 116, 118, and from mechanical design/assembly requirements 132 developed from mechanical specifications 120. Component design, design verification, and fabrication 134, 136, 138 follow component definition 130. Component test specifications 140 are developed in light of the component definition and design 130, 134. Component test and characterization 142 is conducted with fabricated components. The integrated software, tested and characterized components, and system mechanical design all go into final system integration 144.

This methodology has at least two weaknesses. First, the component definition-fabrication cycle is time-consuming, due to the analytical effort required to verify design accuracy before fabrication and due to fabrication time. Second, there is no software-hardware verification until system integration, so interactions between the components and the software which drives them are delayed by the lead time of the new components.

Besides simulation, logic emulation is now also possible. Hardware emulation can perform millions of times faster than comparable simulations, even fast enough to demonstrate design functionality at system speeds. For example, an emulation was used to emulate the video graphics display processor of a personal computer. While a flight simulation program was running on the personal computer, the gate-array emulation of the display processor was operated in real-time to produce screen displays. Waveforms within the emulation model were provided on a separate display screen, allowing operation of the display processor in its intended environment to be monitored.

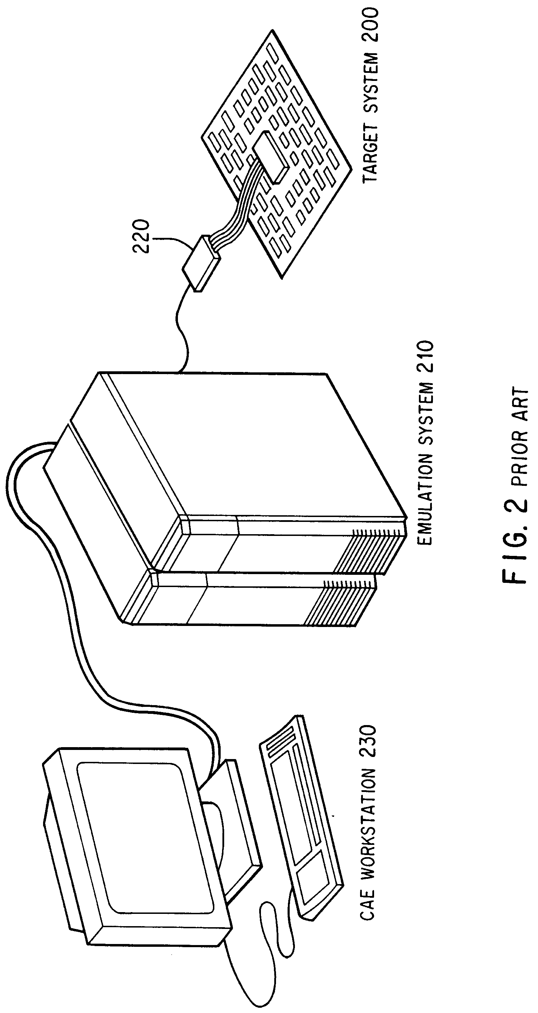

Figure 2 shows a prior-art emulation system for in-circuit emulation of an application-specific IC (ASIC) in a target system 200. Emulation system 210 (e.g., RPM Emulation System™ from Quickturn Systems, Inc., Mountain View, California) connects with a cable assembly 220 to system 200, replacing the ASIC. The ASIC design is loaded from a Computer-Aided Engineering (CAE) workstation 230 into emulation system 210.

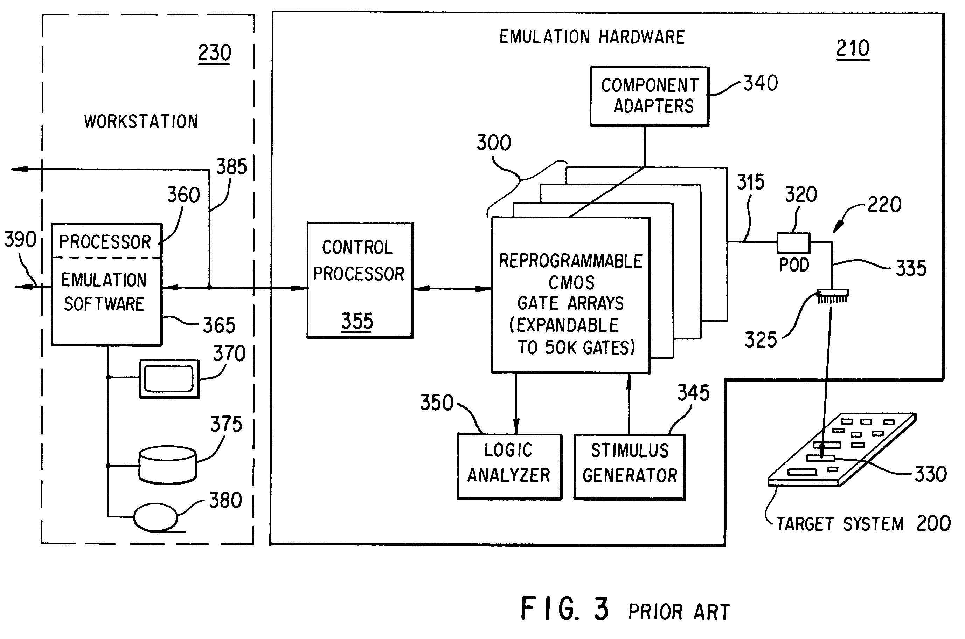

Emulation system hardware 210 (Figure 3) comprises a matrix of reprogrammable CMOS gate arrays 300. Assembly 220 comprises a cable 315 from gate arrays 300 to buffer pod 320, an adapter 325 for connection to ASIC socket 330, and a cable 335 connecting pod 320 to adapter 325. Adapters 340 connected to gate arrays 300 allow existing ICs (e.g., microprocessors, peripherals, memory, & high-speed logic) to be included in the functional emulation of the ASIC. Stimulus generator 345 exercises logic programmed into gate arrays 330 and logic analyzer 350 analyzes the resulting activity. Control processor 355 interfaces workstation 230 to gate arrays 300.

Workstation 230 includes processor 360 programmed with emulation software 365, monitor 370, disk drive 375 and tape drive 380. Connection to other devices or data sources is made through a data bus 385 (*e.g*., a SCSI bus) and/or a network bus 390 (*e.g.*, an Ethernet TCP/IP bus).

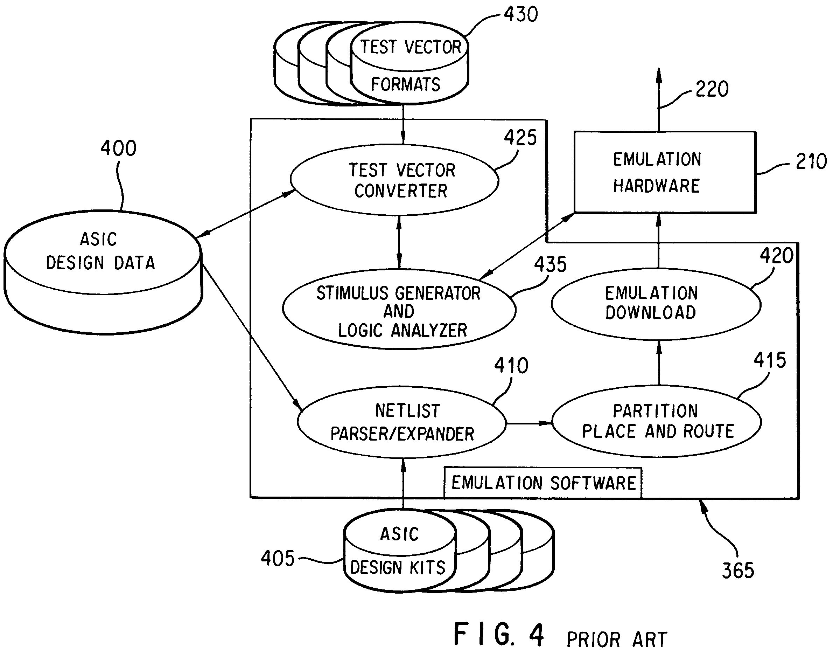

Emulation software 365 receives ASIC design data 400 and ASIC design kits data 405 (Figure 4), and includes functions to parse/expand a netlist (410), place-and-route partitions (415), download emulations (420) to emulation hardware 210, convert test vectors from test vector formats 430 and ASIC design data 400 (425), and control stimulus generator 345 and logic analyser 350 (435).

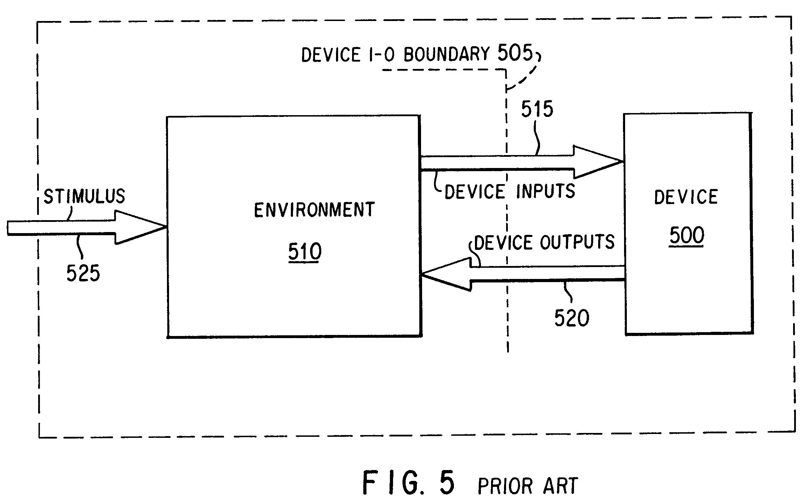

Figure 5 shows use of emulation in a prior art design process. An emulated device 500 (e.g., an ASIC under development) communicates over device I-O boundary 505 with intended environment 510 by means of device input and output 515, 520. External stimulus 525 is applied to environment 510.

Emulation of the target system allows richer exploration of device behavior than does simulation, because it runs at hardware speeds five or more orders of magnitude faster than simulation. With simulation, software models are created and a program is executed which instantiates and interconnects data flows through the models. With emulation, circuits are modeled by programming hardware elements.

However, prior-art emulation of the device and its environment has deficiencies in establishing test vectors. Device timing is ignored -- the emulation model may exhibit race conditions which do not exist in the real device, or *vice versa*. Simulations exhibit indeterminate ("X") states and aid in designing device initialization, while emulations, like real hardware, have no "X" states. Also, there is no inherent "fault model" technology for determining test coverage.

Fault simulation is normally started after the device is designed and production testing is planned. Establishing fault coverage with simulation takes such a long time that production tests are used for which fault coverage is never established. The weakness of the production test shows up as defective devices in the field.

Rules of thumb based on complexity of the circuit to be tested are used to determine whether the circuit is testable, without fully evaluating the test. More complex circuits make test decisions based on such heuristic inferences less reliable. Designers add circuitry for the purpose of making tests, making the overall circuit even more complex and possibly including redundant testability features. It would be preferable to cost-effectively generate and evaluate a production test as a part of the design process, assuring testability of the circuit before production.

### SUMMARY OF THE INVENTION

Test pattern generation and execution by environment emulation offers reduction in the time required for test development, test validation and debug, test quality (fault coverage) measurement, and device debug.

In preferred embodiments, generation and evaluation of test patterns for logic circuits are enhanced by emulating the logic circuit. Two emulations are created: one is a "good" model containing no faults, the other is a "faultable" model which can be selectively faulted. A fault is introduced in the faultable model. The two models are exercised in parallel by applying the same pattern of test vectors to both models. The pattern may be generated by an emulation of the intended operating environment. Differences in the output signals of the two models indicate that the fault has been detected. The test pattern is applied for each of a sequence of possible faults, to determine the extent to which the test pattern enables detection of faults. A fault dictionary entry may be recorded which identifies the test vector at which a fault is detected, the output signal differences indicative of fault detection, and a log of detected faults.

Techniques are described to model faults, sequentially activate the faults in hardware time, recover the fault dictionary entries, and extract the logic pattern for a test program in a format easily adaptable to standard automated test equipment (ATE).

Preferred methods allow introduction of such fault types as latchup, shorted nodes, interrupted nets, etc. Fault emulation time is much less than fault simulation, allowing thorough fault coverage analysis and extensive, varied fault models. Fault coverage for a specific device having about 10,000 gates would be determined by injecting over 32,000 faults in the device emulation, with full emulation testing of each fault. The process should require only minutes to achieve full fault-grading of the device and generate a fault dictionary, compared to an estimated 30 to 60 hours using simulation with single-stuck-at fault injection.

Also, debug of a device, which may contain faults, is facilitated by substituting the device for one of the emulation models. A test pattern is applied to the device and to the emulation model. Output signals of the device are compared with output signals of the emulation model for each vector of the pattern. If the emulation model is non-faulted and no output signal difference is detected, it is assumed that the device contains no faults. If the comparison shows a difference, the fault dictionary is consulted to locate a matching entry to determine the nature of the fault in the device. If faults of more than one kind have identical fault dictionary entries, the test pattern is revised to allow the faults to be distinguished. The revised test pattern is applied to the device and to an emulation model and the results compared again; in this case, a fault suspected to exist in the device is preferably introduced in the emulation model to aid in identification of the fault.

### BRIEF DESCRIPTION OF THE DRAWING

Preferred embodiments are described with reference to the drawing Figures, in which:
Figure 1 illustrates a methodology traditionally employed in design of IC-based systems;
Figure 2 illustrates use of a prior-art emulation system for emulation of an ASIC in a system;
Figure 3 shows principal elements of a prior-art in-circuit emulation system;
Figure 4 shows emulation software functions in the system of Figure 3;
Figure 5 illustrates use of emulations in the prior art design process;
Figure 6 illustrates preferred methods of the invention involving modifications to the prior-art design process of Figure 1;
Figure 7 illustrates test emulation with environment emulation and device emulation in accordance with the invention;
Figure 8 illustrates fault emulation using a selectively faultable emulation model and a non-faulted emulation model in accordance with the invention;
Figure 9 illustrates testing an actual device using environment emulation in accordance with the invention;
Figure 10 is a schematic diagram of a 64x64 cross-point multiplexer;
Figure 11 is a diagram of the intended operating environment of the multiplexer of Figure 10;
Figure 12 is a block diagram of the operating environment of Figure 11, simplified for emulation;
Figure 13 is a block diagram of the CPU control portion of Figure 12;
Figure 14 shows a timing diagram for the emulation sequence of the multiplexer and environment of Figures 10-13 in accordance with the invention;
Figure 15 shows an X-state initialization model of a latch;
Figure 16 shows an initialization model of an OR gate;
Figure 17 shows an initialization model of an AND gate;
Figure 18 is a diagram of a fault injector for selective injection of any of four types of fault in an emulation model;
Figure 19 is a diagram of a faultable emulation model of an AND gate cell of the crosspoint multiplexer of Figure 10; and
Figure 20 is a diagram of a faultable emulation model of an AND gate illustrating how faults may be sequentially introduced.

### DESCRIPTION OF THE PREFERRED EMBODIMENTS

In accordance with preferred embodiments of the invention, device emulation and environment emulation are combined to model the behavior of a target device (*e.g.*, an ASIC under development) in its intended environment. Commercially available gate array emulation technology may be used, such as the Quickturn RPM Emulation System. Activity patterns monitored during the emulation are translated into test vector sets for standard automatic test equipment (ATE). Such emulation offers solutions to problems in initialization and test coverage.

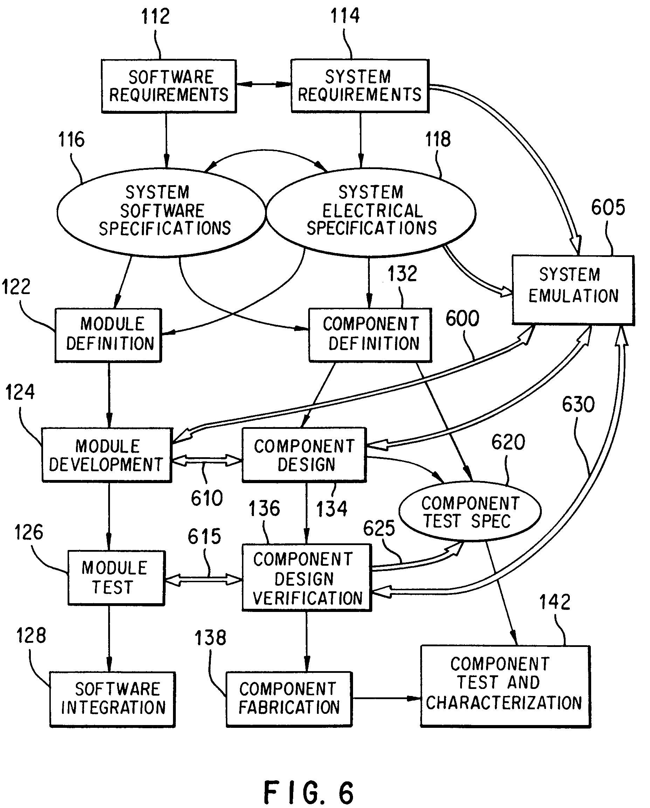

Preferred methods of the present invention involve modifications to the prior-art design process described above. Figure 6 shows the lower left portion of Figure 1 with proposed modifications in accordance with the present invention. Like steps of the process are shown with like reference numerals.

Arrow 600 indicates that software module development 124 is tightly integrated with system emulation 605. Arrow 610 indicates that software module development 124 is integrated with custom component design 134. Arrow 615 indicates that software module test 126 is tightly integrated with component design verification 136. Arrow 625 indicates that component test specification 620 is tightly integrated with component design verification 136. Arrow 630 indicates that component design verification 625 is tightly integrated with system emulation 605, allowing design changes to be evaluated in the system context. A benefit is that circuit portions which are unnecessary or inadequately tested can be discovered early in the design process. The design and/or the test may be modified during the process to assure streamlined design and full fault-coverage during production testing.

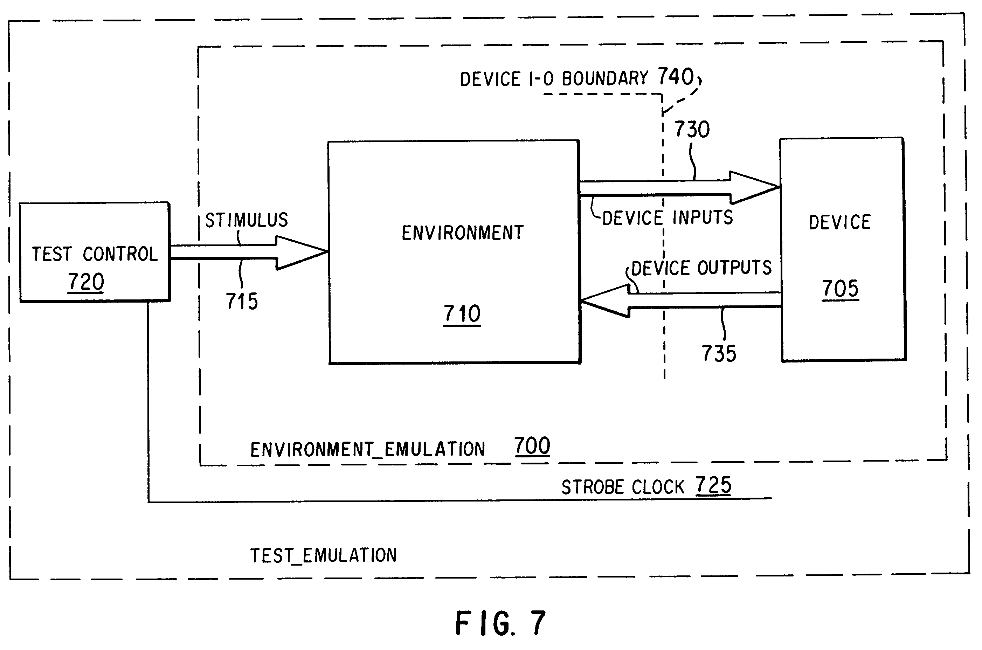

Referring to Figure 7, a simplified emulation model 700 of the target environment is created, including an emulation 705 of the device and an emulation 710 of the environment. The device design is tested for functionality with the environment by providing stimulus 715 to environment 710 from a test control system 720 responsive to a strobe clock signal 725. Device emulation 705 is exercised by environment 710, receiving device inputs 730 and generating device outputs 735 over a device input/output boundary 740 just like an actual device operating in its intended environment.

Once functionality goals are achieved, the test generation procedure begins, comprising the following principal steps:
1. Create test sequence activity.
2. Verify device initialization.
3. Measure fault coverage (modifying test sequence activity as required).
4. Capture resulting test vectors.

Device initialization, fault-coverage measurement, and final test development are separable tasks, as will be seen from the description below.

Preferred test generation procedures differ from the traditional approach. First, fault coverage is measured prior to test vector generation. The test vector set used to test the device is not written down until it has been determined that the environment emulation exercises the device fully enough to locate all logic design defects and uncover fabrication defects which might occur. Second, the time required for thoroughly "fault grading" the test (determining the percentage of all possible faults in the device which are detected by the test) is profoundly reduced. Third, the environment emulation methodology will be more likely to identity design defects even as the test is being generated.

Test sequence activity consists of one or more high-level events which drive the environment emulation model. These events may be a simple "push of the START button" or may comprise a series of events (interrupts, data pattern sequences, etc.). Each event of the test sequence activity may result in generation of hundreds or thousands of standard test vectors.

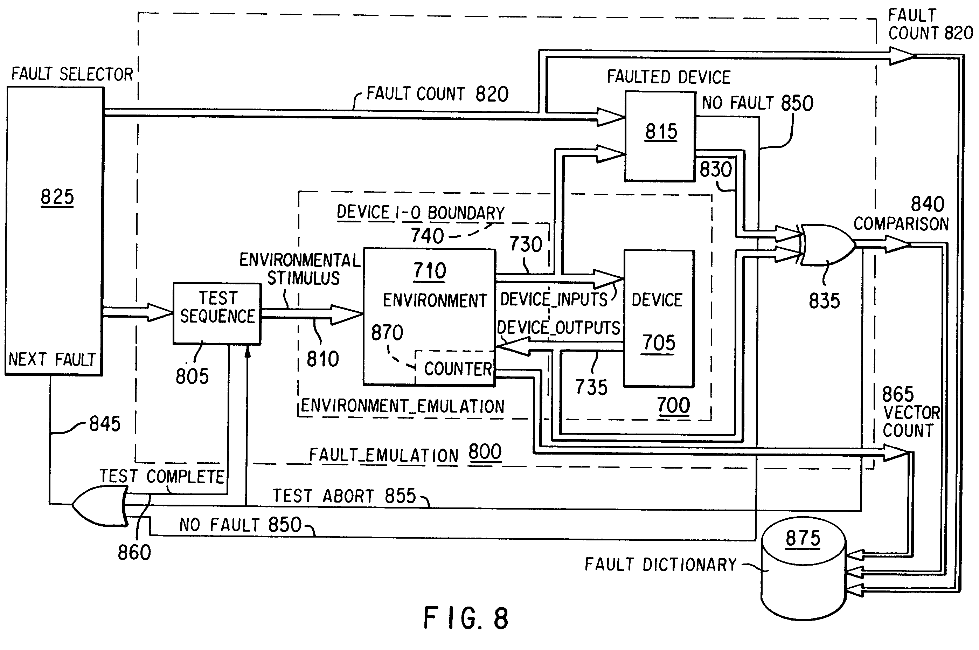

Figure 8 shows how this is done. Fault emulation model 800 is constructed around environment emulation 700. Test sequence activity generator 805 supplies environmental stimulus 810 to an emulated environment 710 which interacts with emulated device 705 via device input and output signals 730, 735 over device I/O boundary 740. Emulated device 705 is a non-faulted, "good" device emulation which performs in accordance with the intended design of the target device.

A second emulation 815 of the target device, which has the capability of being selectively faulted, operates in parallel with non-faulted target device emulation 705. "Faulted" device emulation 815 and "good" device emulation 705 are driven by the same device inputs 730. Faults are selectively introduced in device emulation 815 in response to fault count signal 820 from fault selector 825.

Output signals 735 of "good" emulation 705 are combined with output signals 830 of "faulted" emulation 815 in an exclusive-OR operation represented by XOR gate 835 to produce comparison signal 840. For a given fault introduced into "faulted" emulation 815, comparison signal 840 will indicate any difference which arises between the output signals 735 from "good" emulation 705 ad the output signals 830 from "faulted" emulation 815 during simultaneous operation of the "good" and "faulted" device emulations in the emulated environment.

Fault selector 825 preferably introduces faults in "faulted" device 815 sequentially by incrementing fault count signal 820 in response to next-fault signal 845. Next-fault signal 845 is produced by combining three signals in an "OR" operation: no-fault signal 850 from faulted device 815, test-abort signal 855 from XOR gate 835, and test-complete signal 860 from test sequence generator 805. No-fault signal 850 from faulted device 815 indicates that no fault has been introduced into "faulted" device 815 by the present fault count signal 820, which may occur for example when fault count signal 820 is incremented through a sequence which includes faulted as well as non-faulted operating conditions of the target device. In this case, time is saved by jumping to the next fault in the sequence of faults. Test-abort signal 855 indicates that a fault condition has been detected for the present fault in "faulted" device 815. In this case, time is saved by terminating the test sequence and jumping to the next fault. Test-abort signal 855 is preferably the same as, or is derived from, comparison signal 840. Test-complete signal 860 indicates that the test sequence has been completed for the present fault in "faulted" device 815 without the fault having been detected.

Events making up environmental stimulus 810 result in a succession of logic pattern changes in device inputs 730 and device outputs 735 over device I/O boundary 740. Each change of logic state across device I/O boundary 740 causes the output signal 865 of counter 870, to be incremented. Output signal 865 is a "vector count" uniquely identifying each change of logic state across device I/O boundary 740. For each fault introduced, fault count signal 820, comparison signal 840, and vector count signal 865 are recorded as an entry in fault dictionary 875.

By sequentially introducing faults into "faulted" device emulation 815 and comparing the results with non-faulted device emulation 500 in an emulation of the intended operating environment, a fault dictionary 870 is developed which indicates at which vector of the environment emulation operating sequence, if any, each fault is exhibited in the output signals of the device.

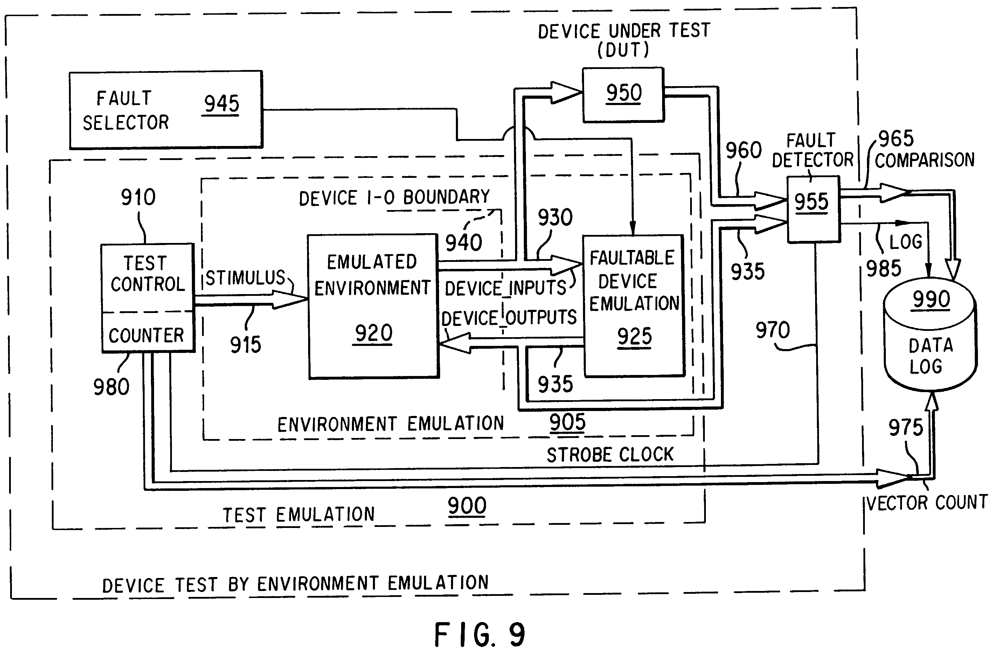

Figure 9 illustrates how an actual device (rather than an emulated device) may be tested by environment emulation. Test emulation model 900 is constructed around an environment emulation model 905. Test control generator 910 supplies environmental stimulus 915 to an emulated environment 920 which interacts with a device emulation model 925 by input and output signals 930, 935 over device I/O boundary 940. Model 925 is preferably a faultable model into which faults may be selectively introduced by fault selector 945. Model 925 is initially a non-faulted, "good" device emulation which performs in accordance with the intended design of the target device when no faults are introduced.

An actual device under test (DUT) 950 is operated in parallel with model 925, both being driven by device input signals 930. Output signals 935 of model 925 and output signals 960 of DUT 950 are supplied to fault detector 955. Fault detector 955 produces a comparison signal 965 indicative of any differences between output signals 935 and the signals 960 at the output pins of device 950 --the "fail" pattern. Fault detection timing is under control of a strobe-clock signal 970 from test control generator 910.

Vector-count signals 975 from counter 980 within test control generator 910 (or within the emulated environment, as in Figure 8) indicate which test vector of a sequence is currently applied to environment emulation 905. Fault detector 955 produces log signal 985 which triggers recording of comparison signal 965 and vector count signal 975 in data log 990 upon detection of a fault.

Data log 990 is used to analyze performance of DUT 950. Results obtained in testing DUT 950 may be compared with entries in fault dictionary 870 to determine the nature of any fault detected during environment emulation testing of DUT 950. DUT output signals 960 are compared with model output signals 935 for each test vector. If emulation model 925 is non-faulted and no output signal difference is detected, DUT 950 is assumed to contain no faults of a kind detectable with this test vector pattern. If the comparison shows a difference, a fault dictionary is consulted to locate a matching failure pattern entry to determine the nature of the fault in the DUT. If the fault dictionary identifies a plurality of faults which give rise to the same failure pattern, the test vector pattern is revised for debug purposes to allow these faults to be distinguished. (Typically, a test vector pattern for production testing is devised to assure that all fault types will be detected but without uniquely identifying the failure pattern.)

The revised test pattern is applied to the device ad to the faultable emulation model and the results compared again; in this case, a fault suspected to exist in the device is preferably introduced in the emulation model to aid in identification of the nature of the fault. A series of suspected faults can be introduced successively into the faultable emulation model and the test vector sequence re-run for each in order to further characterise the actual fault in the DUT.

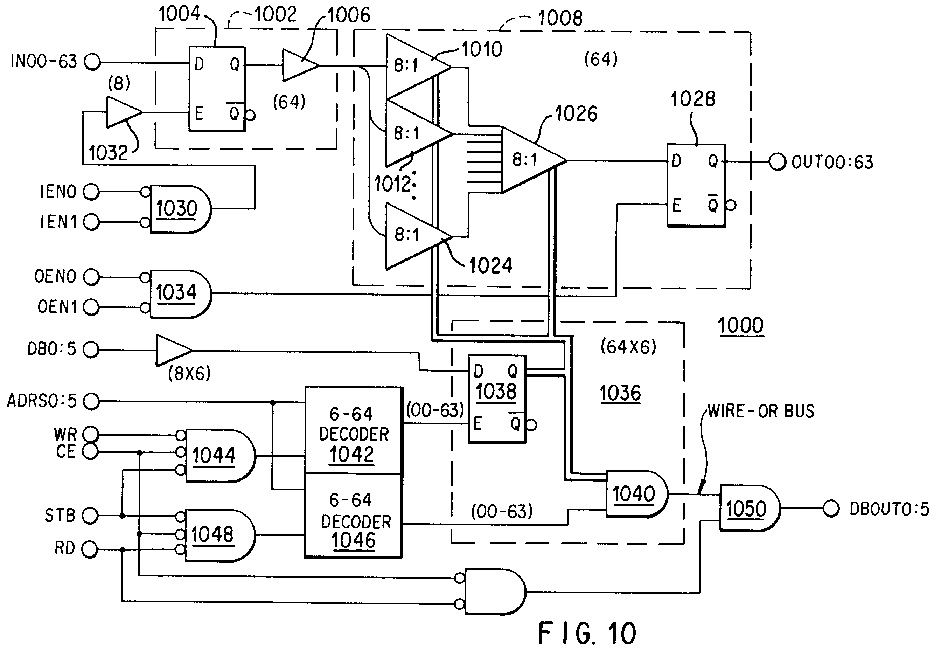

Principles of the invention may be applied, e.g., to the design of a 64x64 crosspoint multiplexer (mux) shown at 1000 in the simplified schematic of Figure 10. The mux is a custom circuit which routes any of 64 inputs to any or all of 64 outputs. The task is to generate an ATE production test.

A sequence of environment actions is to be established to exercise the mux sufficiently to extract all test vectors. While more environment emulations might be required to achieve this purpose for a given device, a single simplified environment is planned to fully exercise the device in this example. It is anticipated that about a dozen successive environment-stimulus events would produce a test pattern of about 14,000 vectors. Each event serves to:
1. initialize the target device by emulating a CPU register-write sequence;
2. establish a starting value for a pseudo-random data path exerciser; and
3. generate a data burst from the data path exerciser.
The events are defined by a pattern generator, e.g., stimulus generator 345.

Mux 1000 is emulated several times, each time using specialized gate models created for each step in the test generation process. Two types of gate models may be used: X-state models and faultable models. The environment is emulated using simple gate-level logic models.

Target Device Description: Mux 1000 has 64 input lines (IN 00-63) and 64 output lines (OUT 00:63). An input latch circuit 1002 is provided for each input line, comprising latch 1004 and output driver 1006. An output latch circuit 1008 for each output line comprises a bank of eight selectively-addressable 8:1 drivers 1010 - 1024 feeding a selectively-addressable 8:1 driver 1026 which drives an output latch 1028.

Input enable gate 1030 supplies an enable signal via drivers 1032 to latch data on input lines IN 00-63 into respective input latch circuits 1002 at input enable (IEN) time in response to input enable signals (IEN0, IEN1). Output enable gate 1034 enables the data from input latch circuits 1002 into the selected output lines (OUT 00:63) at output enable (OEN) time. The latched input (IN 00-63) and output (OUT 00:63) lines represent stages of a data distribution pipeline. Respective output lines to which data on input lines are to be routed are selected by writing the address of the selected input line into the selection register 1036 for the selected output line. When write-enable signal WR, chip enable signal CE and strobe signal STB are low, decoder 1042 enables latches 1038 corresponding to the output address on lines ADRS 0:5. The input-line address on data-bus lines DB0:5 is entered in the enabled latches 1038 to enable appropriate drivers 1010-1026. When read-enable signal RD, chip enable signal CE and strobe signal STB are all low, decoder 1046 decodes a output-line address appearing on lines ADRS 0:5. Data in corresponding latches 1038, representing input lines of mux 1000 to which that output line of mux 1000 is connected, are supplied via gates 1040 and 1050 to data-bus-out lines DBOUT 0:5.

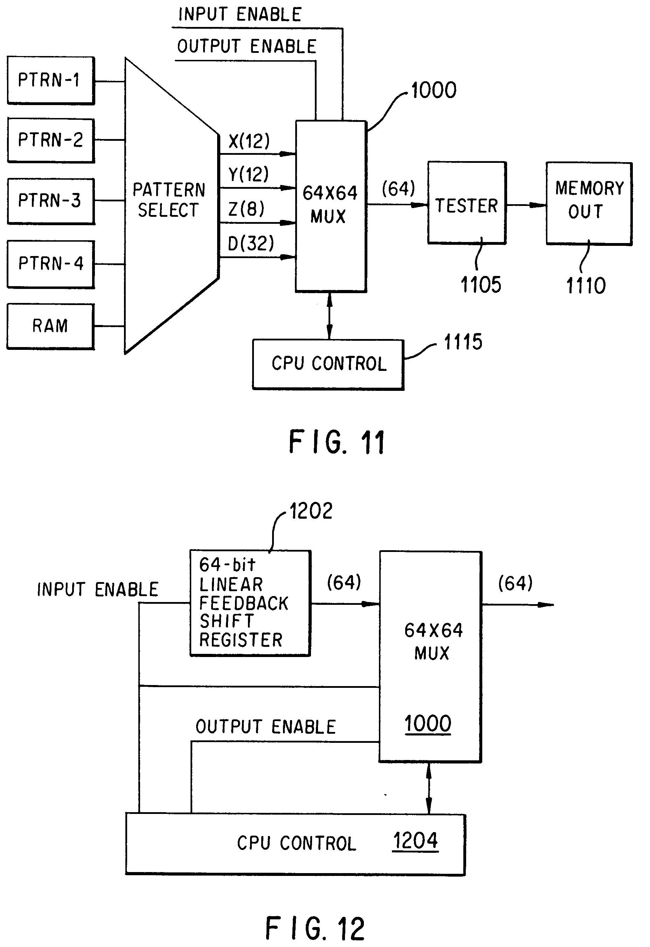

Environment Description: Mux 1000 is to route Algorithmic Pattern Generator (APG) patterns to user-specified pins in a high-pin-count memory-chip ATE system. The environment includes a CPU for writing pin selection information. The block diagram of Figure 11 shows the intended environment of mux 1000. Logic patterns (PTRN-1, etc.) are routed by pattern selection logic 1100 to 12-bit X address lines, 12-bit Y address lines, 8-bit Z address lines ad 32-bit data (D) lines of mux 1000. The patterns are determined by requirements of the DUT. Address and data lines from pattern selection logic 1100 are mapped by mux 1000 into pin-driver channels of a tester 1105 connected to the pins of the memory DUT 1110. Mux 1000 is under control of a CPU controller 1115.

The Figure 11 environment is more complex than needed to fully exercise mux 1000, and can be simplified for emulation (Figure 12) by replacing the APG with a 64-bit feedback shift register 1202 functioning as a pseudo-random pattern generator (PRG) and supplying address and data signals to mux 1000. CPU controller 1204 supplies input-enable and output-enable signals and controls mux operation. Register 1202 is clocked on the rising edge of the (negative-going) input-enable pulse, so it commences changing state only after input registers of mux 1000 are latched. The environment emulation creates pseudorandom patterns and propagates them through mux 1000. For special cases, register 1202 may be replaced with other pattern sources (*e.g.*, counters).

The main emulation problem lies in the control task of CPU 1204, as the test must guarantee all possible connections through mux 1000. The control mechanism of CPU 1204 must behave like pattern selection logic 1100 (Figure 11), e.g., routing one mux input to all mux outputs, alternating two mux inputs, or distributing all mux inputs in various ways to all mux outputs. All these operations are synchronized by read and/or write processes under control of CPU 1204.

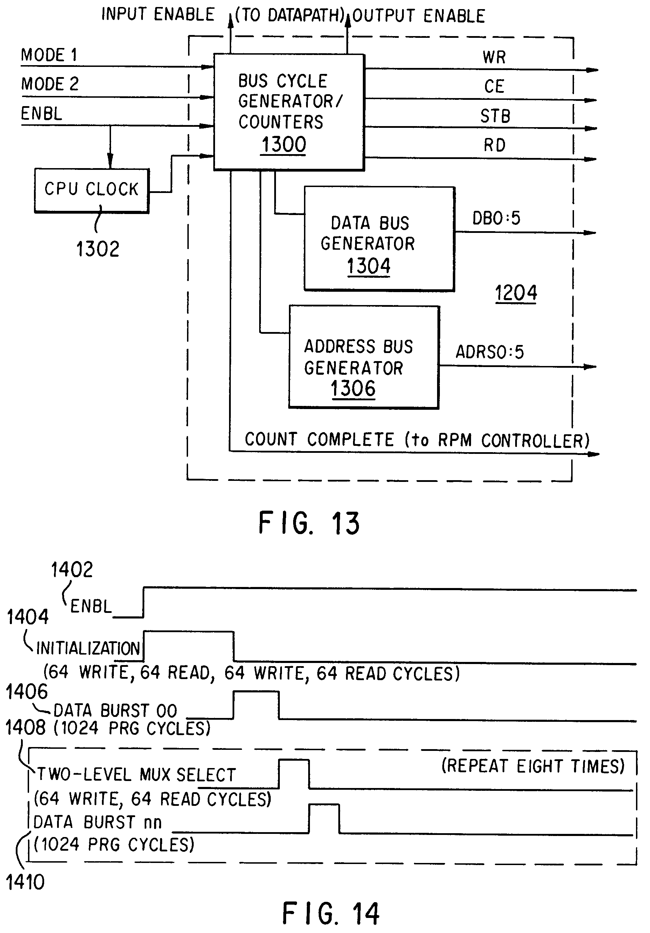

Figure 13 is a block diagram of CPU control portion 1204. Bus cycle generator/counters 1300 are controlled by external "mode" bits (MODE1 and MODE2) which determine whether a read or a write cycle is enabled when emulation activity is launched. Emulation activity is launched when CPU clock 1302 is enabled by signal ENBL after initialization. The "mode" bits and signal ENBL correspond to environmental stimulus 810 and are generated by stimulus generator 345 (Figure 3) from stored setup data. Several different stimulus patterns are generated by stimulus generator 345, each representing an environmental event, e.g., a CPU command to execute a read-write cycle.

Data bus generator 1304 has a counter to generate a activity pattern on data bus lines DB0:5. Address bus generator 1306 has a counter which generates an activity pattern on address bus lines ADRS0:5. Databus lines DB0:5 are used to select a mux input which is to be connected to a mux output selected on address bus lines ADRS0:5. During initialization, data bus generator 1304 and address bus generator 1306 are loaded with starting count and count rate values from stimulus generator 345 which, together with the environmental stimulus from generator 345, determine the exercise requirements to be implemented. E.g., one requirement is to check that various assignments of mux inputs to mux outputs are operable. Different count rate values of data bus generator 1304 and address bus generator 1306 determine how many mux output lines are connected to each selected mux input line, *i.e.*, how many address bus changes occur for each data bus change. Starting count values of generators 1304, 1306 determine which mux output lines are initially connected to the selected mux input line. Bus cycle generator/counters 1300 supply signals WR, CE, STB and RD, drive generator 1304 which supplies data-bus signals DB0:5 ad generator 1306 which supplies address signals ADRS0:5, and supply COUNT COMPLETE signals to control processor 355 (Figure 3) to signal the end of a test sequence.

Device Initialization: The initial (power-on) state of the device emulation, like that of a production circuit, normally depends on unpredictable process parameters. The initial state of the emulation almost certainly will not coincide with that of the circuit it models. If the device design incorporates adequate initialization circuitry, initialization should not be a problem. If not, methods may be employed to assure proper initialization. One method is to define a logic sequence which initializes all logic elements of the device design when applied to the emulation.

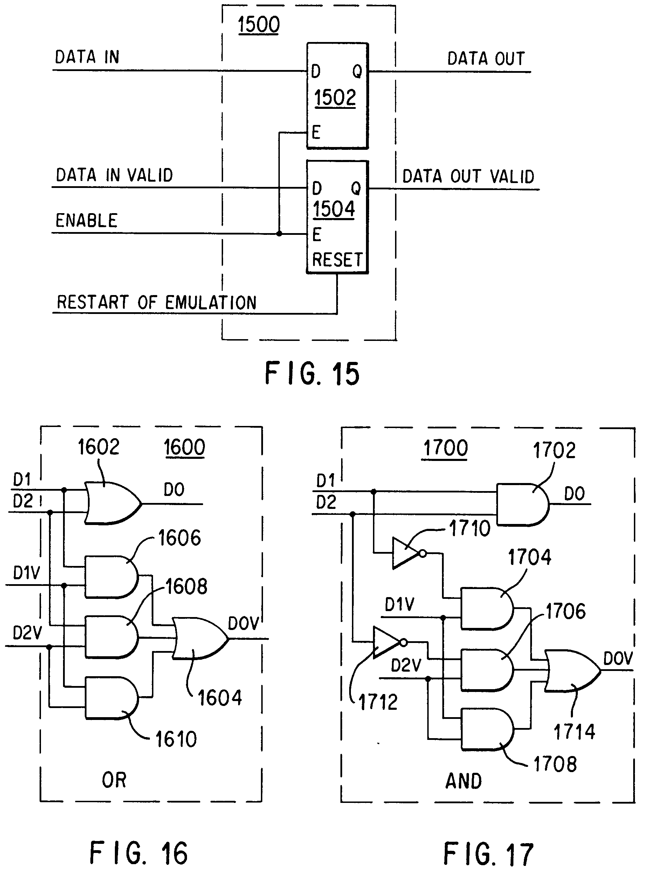

Another method is to emulate the device using augmented models (e.g., of gates, latches and flip-flops) which can store and propagate initialization information along with state information. Initialization issues come in two forms: (1) unknown internal states, and (2) propagation of indeterminate state data. To verify device initialization, X-state models incorporate a "data valid" term which propagates with the logic signal. X-state models are only required in those cases where device inputs come from internal circuits with state or circuits with feedback, but can be used for all cells. Figure 15 shows an X-state model 1500 of a single latch, constructed of emulator latches 1502, 1504. The "D" input and "Q" output lines of latch 1502 serve as primary data input and output lines. The Data Out Valid signal is reset to a low state at the start of emulation by signal Enable, because the output of a data latch cannot be known until data has been latched into it.

When signal Enable goes high, Data In propagates to Data Out and Data In Valid propagates to Data Out Valid. Then, Data Out Valid remains high if Data In Valid is high whenever Data In is high.

Figure 16 shows a model 1600 of a single OR gate, constructed of OR gates 1602, 1604 and AND gates 1606, 1608, 1610. D1 and D2 are primary inputs. DO is valid when values for D1 and D2 are specified. If D1 or D2 is high, DO is high. For example, If D1 is known to be valid (indicated by signal D1V being high) and D1 is high, AND gate 1606 supplies a data out valid signal DOV via OR gate 1604 which says that signal DO is valid. DOV is passed to the next gate downstream of model 1600 to indicate that signal DO is valid, e.g., not indeterminate. If D2 is high but not known to be valid (e.g., when the emulator hardware is powered up), then D2V is low because D2 has not been intentionally driven high. When D1 goes from high to low, DOV also goes from high to low, indicating that signal DO from OR gate 1602 cannot be trusted as valid. Figure 17 shows an initialization model 1700 of a single AND gate (constructed of AND gates 1702, 1704, 1706, 1708, drivers 1710, 1712, and OR gate 1714) which operates in a manner similar to model 1600.

Functioning of data valid signals is the same in all of models 1500, 1600 and 1700, indicating whether data conditions are valid throughout the logic device. The DOV signal of a gate which receives primary input signals is true because all of its inputs are known. The DOV term of each latch is set to false by resetting at the start of emulation. As the test sequence runs, a point is ultimately reached where all DOV signals are true; at that point the entire device state is known. More complex elements are implemented either from the primitives of Figures 15-17, or in a similar fashion. This process transforms the two-state emulator into a three-state emulator. Before environment or device emulation commences, a system reset occurs so that all DOV terms associated with the storage elements or propagations from them become FALSE. Emulation with initialization requires more hardware elements than normal emulation, but there is no execution time penalty. Gates driven by primary inputs do not need the expanded model.

Fault Emulation: Two copies (emulation models) of the target circuit are created. The first copy (the "good" emulation model) consists of standard logic models. The second copy (the "faultable" emulation model) is modified so that a significant subset of it is instantiated with faultable models. For fault emulation, logic models of each cell incorporating "all possible" faults are used. For the purposes of this example, four different fault types are used: shorted stuck-at ONE, shorted stuck-at ZERO, open stuck-at ONE, and open stuck-at ZERO. A shorted fault exists at a device output -- everything on the net sees the fault. An open fault is at a device input -- only that device sees the fault.

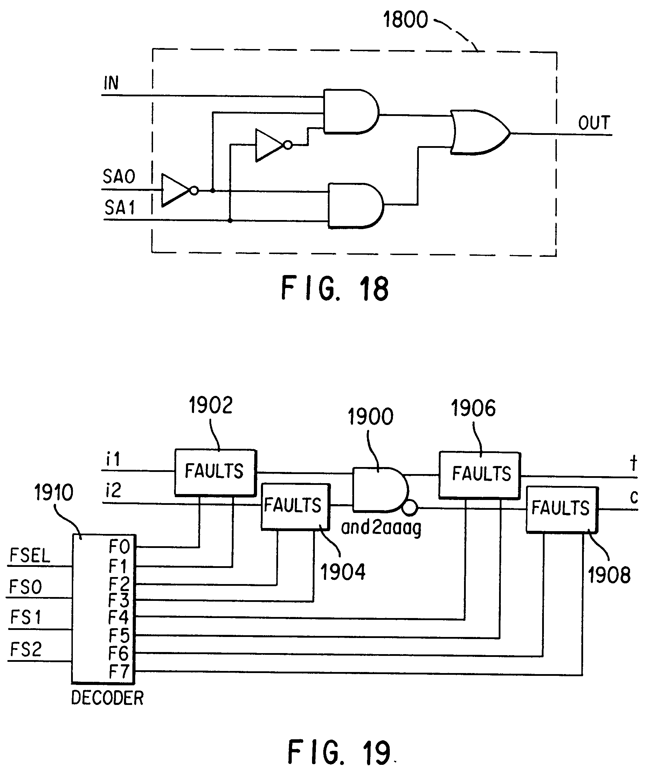

Figure 18 shows a fault injector 1800 which allows selective injection of any of these fault types. If "stuck-at" lines SA0 and SA1 are both LOW, the output follows the input. If "stuck-at" line SA1 is HIGH, the output is forced HIGH. If "stuck-at" line SA0 is HIGH, the output is forced LOW. A copy of fault injector 1800 is introduced in the emulation of a device wherever fault injection is desired. E.g., for each gate of mux 1000, a fault model is created which incorporates all possible faults of the above types, together with a decoder for activating each of the possible faults in that gate in succession. There are 10 different logic cells in the detailed design of mux 1000, each cell having a number of possible stuck-at faults. The following table lists for each cell of mux 1000 the cell type, the number of stuck-at faults, the number of use counts and the number of total faults:

| Cell | Cell type | Stuck-at faults | Use counts | Total faults |
|---|---|---|---|---|
| 1. | and2aaag | 8 | 70 | 560 |
| 2. | or02aaag | 8 | 3 | 24 |
| 3. | or08aaag | 20 | 54 | 1080 |
| 4. | oai21iig | 14 | 2 | 28 |
| 5. | and4haag | 12 | 18 | 216 |
| 6. | bufhhaag | 6 | 129 | 774 |
| 7. | bufhhiig | 6 | 74 | 444 |
| 8. | mux8haag | 36 | 576 | 20736 |
| 9. | dec24eig | 14 | 272 | 3808 |
| 10. | laalaag | 8 | 518 | 5180 |

Fig. 19 shows a fault model of AND gate "and2aaag" of mux 1000 having fault injectors 1902, 1904 in input lines "i1" and "i2" ad fault injectors 1906, 1908 in output lines "t" and "c". A decoder 1910 having input lines FSEL, FS0, FS1 and FS2 and output lines F0-F7 allows any of the possible faults to be introduced by supplying the appropriate fault command to decoder 1910. Other fault injection techniques could be used.

In some cases the gate arrays do not have enough gates to simultaneously emulate the environment and a "good" device model and a "faulted" device model containing all possible faults. If this occurs, a series of "faulted" device models may be programmed in sequence, with each "faulted" device model having a different subset of its cells made up of "faulted" cell models and the remainder made up of "good" cell models. A first "faulted" device model is used for sequential injection of all possible faults of a first subset of cells. The emulation is then reprogrammed so that a second "faulted" device model is used for sequential injection of all possible faults of a second subset of cells, and so on until all possible faults have been explored. Reprogramming time is small, so the efficiency of emulation remains high when compared with simulation.

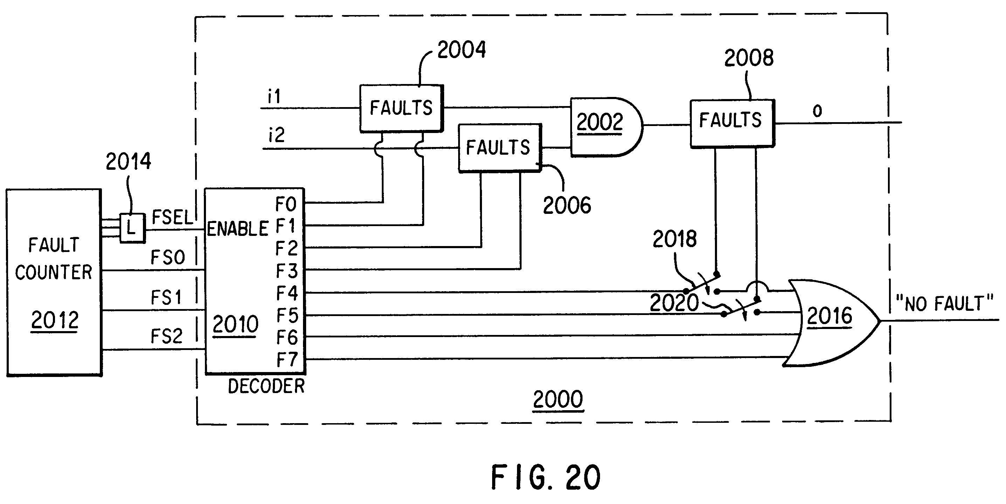

Fig. 20 shows a faultable emulation model 2000 of an AND gate showing how faults are sequentially introduced. AND gate 2002 has fault injectors 2004, 2006 in its input lines i1, i2 and a fault injector 2008 in its output line O. Fault-count decoder 2010 activates fault injectors in sequence as the fault count from counter 2012 within selector 825 (Fig. 8) is incremented. Decoder 2010 is a 3-line to 8-line decoder with enable, which permits numerical assignment of each fault for record-keeping. Decoder 2014 decodes additional counter bits to make possible fault injection for multiple circuits.

Fault insertion decoding is simplified by expanding each fault model decoder to a power of 2 and associating unused counts with a "no-fault" output signal, e.g.:

| Fault Count | Fault Condition |
|---|---|
| 00 | i2 stuck at 0 |
| 01 | i2 stuck at 1 |
| 02 | i1 stuck at 0 |
| 03 | i1 stuck at 1 |
| 04 | O stuck at 0 |
| 05 | O stuck at 1 |
| 06 | no_fault |
| 07 | no_fault |

As fault counts 06 and 07 are not needed to activate faults, they go to OR gate 2016 which provides a "no-fault" output signal. OR gate 2016 is shown possibly connected (by switches 2018 and 2020) to the two output fault cases, indicating that these faults can be disabled in a specific model instance if a circuit being modeled is not subject to that particular fault. Input fault cases could be similarly disabled. The "no-fault" output signal of OR gate 2016, combined with no-fault signals from other faultable circuit models, is used to abort emulation test sequences by during fault detection analysis.

Operation of the Emulation System: After loading the emulation and the selected logic analyzer connections into the emulation hardware, the mode bits and other initialization values are set and CPU clock 1302 (Figure 13) is enabled to commence operation. CPU clock 1302 is gated by signal ENBL, assuring synchronous operation of bus cycle generator/counters 1300 and the other circuitry. The datapath latch clocking of the emulation model of mux 1000 is also driven by bus cycle generator/counters circuitry 1300, so the dataflow process is properly synchronized with mux path selection. The bus cycle control generates the read (RD), write (WR), strobe (STB) and chip-enable (CE) signals and successively loads each of the emulated mux selection registers with a predetermined value to activate the mux datapaths.

A timing diagram for the emulation sequence is shown in Figure 14. The sequence is launched by enable signal ENBL 1402, which corresponds to the push of a "Start Button." An initialization sequence 1404 writes all 64 selection registers of the mux emulation with independent address-coded data values, verifies the values using the readback path, then for each register writes the complement of the data values and verifies the complement values. This establishes that each input of the mux selection registers is connected to one ad only one output of the mux, and that all program bits function. After the initialization sequence, each output of the mux emulation is connected to a separate input path of the mux emulation. A data burst 1406 (comprising 1024 pseudo-random generator cycles) is then supplied by feedback shift register 1202 to the mux emulation, which comes close to assuring that all internal mux inputs are connected. Since it is possible that for some particular data path no change will occur for 1024 cycles, a stuck-at-fault condition on that path would not be detected at this stage. Proof of fault coverage is deferred until fault simulation time.

For the balance of the testing, it is hypothesized that two-level separability of the layers of multiplexing in mux 1000 will permit full cross-point verification in eight cycles of selection ad data distribution, using octal coding of 00, 11, 22, 33, 44, 55, 66, 77 for each latch. Each value is written in all selection registers (line 1408), and then a 1024-cycle burst of activity from feedback shift register 1202 is executed (line 1410). The test sequence so created consists of approximately 14,000 test vectors. It is estimated that execution of such a sequence in a VERILOG simulator would require about 15,000 seconds. In contrast, execution of such a sequence with emulation using a Quickturn RPM Emulation System is estimated to require less than 100 milliseconds.

The two emulation models -- "good" and "faultable" -- are driven in parallel by the environment emulation. The "good" model is used to respond to the environment emulation. Faults are not introduced in the "good" model. Only a subset of the cell models making up the initial "faultable" model are capable of being faulted, due to limited availability of emulator gates. Selectors for the "faultable" model, and the logic which activates them, are both incorporated in the environment emulation. The fault selection logic is driven by a fault selection index counter which is incremented after each full test cycle, logically advancing the "faultable" model to the next stuck-at fault. After all faults of the initial "faultable" model have been emulated, the emulation system is reprogrammed to include a revised "faultable" model for emulation of a different set of faults. It is estimated that an average of 15ms per fault is required for reprogramming.

The planned environment emulation activity sequence is executed for each fault. Output signals of the two models are combined in an exclusive-OR (XOR) operation to determine whether the activated fault has been detected. The fault selection index, the clock cycle number (test vector number), and the fail pattern at the time of fault detection are recorded. This procedure is conceptually similar to traditional fault simulation. However, as the time required to activate each successive fault and execute the full 14,000-vector pattern is less than 100 milliseconds plus model loading overhead, the full test grading process is estimated to require less than one hour for some 32,580 fault insertions.

Emulation makes the processes of augmenting and qualifying the test vector set much less time-consuming than would be the case with simulation. If the 32,580 possible faults of this example were injected individually in a simulation, with a 15,000-second simulation run to verify that each fault was detected by the test pattern, some 120,000 hours of simulation time would be required. Fault simulation is of course not run in this way, but instead uses algorithms which, for an example of this kind, are estimated to require on the order of 30 - 60 hours of processing.

Test Vector Generation and Execution: After fault coverage verification, the actual test pattern can be recorded by running the now fully verified and approved sequence of activity bursts using the "good" emulation of the target device, and recording the input and output logic vectors of the device emulation appearing at the device I/O boundary for each clock cycle. E.g., the "good" device emulation takes the place of device 705 (Fig. 7), and device inputs 730 and device outputs 735 at device I/O boundary 740 are recorded as environment 710 is stimulated by test control system 720. If the number of input and output pins of the emulated device exceeds the available recording capability, the pin activity may be collected in multiple iterations. The recorded logic vector sequence may be ported directly to standard ATE without major effort.

Device Timing and Race Conditions: Emulation is not effective for device timing. Circuit emulations using programmable gate arrays may operate a factor of ten or more slower than the target device. While many device designs do not have potential speed problems (the speed requirement being inherently much less than the emulation process speed), the issue of operation at full rated speed of the target device remains significant. First, detailed timing analysis in software is feasible and typically takes much less execution time than full simulation, though timing library models and related technology are required. Second, limited simulations designed explicitly for timing analysis can be used to verify that the fabricated device will operate at the target speed. Finally, if the issue is more one of speed grading than of achieving a specific operating goal, devices can be built following emulation verification ad then execution speeds can be determined for binning purposes. In any event, traditional ATE systems can be used to establish operating speeds in the production test environment, while environment emulation can be used to develop and verify test vector sets which are to be used to operate the traditional ATE systems for speed verification or binning.

A timing test vector set can be developed and verified using the emulation technology. Then, this (presumably much shorter) vector set can be run on a simulator to establish timing margins and potential device speed. E.g., for mux 1000, VERILOG simulations with sharply restricted vector sets can be used to validate device timing. The actual time spent in timing validation simulation is not large, and simulations need not start until the emulation environment has already proven the overall target device design and the target timing vector set. Translation of the environment and device models into a VERILOG simulation can be accomplished using standard vendor-supplied software.

Those skilled in the art will recognize that the invention is not limited to the described embodiments and that modifications are possible within the spirit and scope of the following claims.

## Claims

1. A method for generating a test for a target logic circuit, comprising the steps of:
a. creating a first emulation of the logic device;
b. creating a second emulation of the logic device, the second emulation including the capability of being selectively faulted;
c. selectively introducing a fault into the second emulation;
d. applying a pattern of test vectors to the first emulation and to the second emulation, to thereby exercise the first emulation and the second emulation;
e. comparing output signals produced by the first emulation and the second emulation in response to each test vector of the series, to thereby detect the selectively introduced fault by detecting any difference between the output signals;
f. upon detection of the selectively introduced fault, producing a record of the fault introduced into the second emulation; and
g. repeating steps c.-f. for each of a sequence of selectively introduced faults, to thereby produce a record indicating which faults of the sequence of faults result in differences between the output signals of the first emulation and the second emulation.

2. The method according to claim 1, wherein step f. further comprises the step of recording an identification of a test vector of the pattern of test vectors at which the selectively introduced fault is detected.

3. The method according to claim 2, wherein step f. further comprises the step of recording a signal indicative of any difference between the output signals upon detection of the selectively introduced fault.

4. A method of testing a logic circuit device, comprising the steps of:
a. preparing a fault dictionary comprising an entry for each of a plurality of possible faults in the device, each said entry identifying the nature of the fault and a test vector of a test vector pattern at which said fault is exhibited at output pins of the device when the test vector pattern is applied to input pins of the device;
b. preparing a emulation model of the device by programming a plurality of gates of a programmable gate array, said emulation model having input lines and output lines corresponding to input pins and output pins of the device;
c. applying the test vector pattern to input pins of the device and to input lines of the emulation model, to thereby exercise the device and the emulation model;
d. for each test vector of the applied test vector pattern, comparing signals appearing at output pins of the device with signals appearing at output lines of the emulation model to produce a comparison signal indicative of any difference between the signals appearing at output pins of the device and the signals appearing at output lines of the emulation model;
e. upon detection of any said difference, recording said comparison signal and an identification of a test vector at which said difference is detected; and
f. comparing the identification of a test vector recorded in step e. with entries of said fault dictionary entries to determine the nature of at least one possible fault in the device which can produce said difference.

5. The method according to claim 4, wherein step a. comprises the steps of:
i. creating a non-faulted emulation model of the logic device;
ii. creating a faultable emulation model of the logic device, the second emulation model including the capability of being selectively faulted;
iii. selectively introducing a fault into the faultable emulation model;
iv. applying a pattern of test vectors to the non-faulted emulation model and to the faultable emulation model, to thereby exercise the non-faulted emulation model and the faultable emulation model;
v. comparing output signals produced by the non-faulted emulation model and the faultable emulation model in response to each test vector of the series, to thereby detect the selectively introduced fault by detecting any difference between the output signals;
vi. upon detection of the selectively introduced fault, producing a record identifying the nature of the fault introduced into the faultable emulation model and a test vector at which the selectively introduced fault is exhibited in output signals of the faultable emulation model; and
vii. repeating steps iii.-vi. for each of a sequence of selectively introduced faults, to thereby produce said fault dictionary.

6. The method according to claim 4, wherein each entry of the fault dictionary further includes a representation of a failure pattern appearing at the output pins of the device when said at least one fault is exhibited, the method further comprising the steps of:
g. introducing in the emulation model a fault of a nature determined in step f., to thereby produce a faulted emulation model;
h. applying a test vector pattern to input pins of the device and to input lines of the faulted emulation model, to thereby exercise the device and the faulted emulation model;
i. for each test vector of the test vector pattern applied in step h., comparing signals appearing at output pins of the device with signals appearing at output lines of the faulted emulation model, to thereby determine whether a failure pattern appearing at the output pins of the device is the same as a failure pattern appearing at the output lines of the faulted emulation model.
